# EUROPÄISCHE PATENTSCHRIFT

(11) **EP 0 660 496 B1**
(45) Veröffentlichungstag und Bekanntmachung des Hinweises auf die Patenterteilung: **30.09.1998**
(21) Anmeldenummer: 94810687.7
(22) Anmeldetag: 02.12.1994
(51) Int. Cl.: H02M 7/00

(54) **Umrichteranordnung mit niederinduktivem Kommutierungskreis**
Converter device with low-inductive commutation loop
Dispositif convertisseur avec une boucle de commutation de faible inductance

(30) Priorität: 23.12.1993 DE 4344135
(43) Veröffentlichungstag der Anmeldung: 28.06.1995
(73) Patentinhaber: Asea Brown Boveri AG, 5401 Baden (CH)
(72) Erfinder: Beriger, Conrad,, CH-5000 Aarau (CH); Grüning, Horst, Dr., CH-5430 Wettingen (CH); Stemmler, Herbert, Prof.Dr., CH-5416 Kirchdorf (CH); Werninger, Johannes, CH-8008 Zürich (CH)

(56) Entgegenhaltungen:
- EP-A- 0 500 032
- DE-A- 4 023 687
- DE-U- 9 309 428
- US-A- 4 617 621

## Beschreibung

### Technisches Gebiet

Die Erfindung bezieht sich auf das Gebiet der Leistungselektronik.

Sie geht aus von einer Umrichteranordnung nach dem Oberbegriff des ersten Anspruchs.

### Stand der Technik

Eine solche Umrichteranordnung wird beispielsweise schon in der Deutschen Offenlegungsschrift DE 40 23 687 A1 beschrieben.

Es handelt sich dabei um einen sogenannten U-Umrichter, d.h. um einen Umrichter mit Gleichspannungszwischenkreis und Kondensator-Bank. Ein solcher Umrichter umfasst im Normalfall mehrere Phasen, die aus je zwei Zweigmodulen bestehen. Die Zweigmodule weisen mindestens zwei Schaltermodule auf, die in Serie geschaltet sind und mit ihrem Mittelanschluss einen Lastanschluss bilden. Durch abwechselndes Ein- und Ausschalten der Schalter eines Zweiges wird an den Lastanschluss entweder die positive oder die negative Spannung des Gleichspannungszwischenkreises geschaltet.

Im Gegensatz dazu wurden bis vor kurzer Zeit vor allem sog. I-Umrichter verwendet, d.h. Umrichter, die anstatt einer Kondensator-Bank eine grosse Induktivität aufweisen, welche die beiden Dreiphasenbrücken entkoppelt. Da also im Zwischenkreis sowieso schon eine grosse Induktivität vorhanden war, mussten die Schaltungsanordnungen bezüglich parasitären Induktivitäten nicht optimiert werden.

Beim U-Umrichter haben nun aber parasitäre Induktivitäten einen nicht zu vernachlässigenden Einfluss. Insbesondere bei der Kommutierung des Stroms von einem Brückenzweig zum anderen sollte dem Kommutierungsstrom möglichst keine Induktivität entgegengesetzt werden, damit beim Umschalten nach U_{L} = L*(di/dt) möglichst wenig Spannung über dem Halbleiter auftritt.

Deshalb wird in der Europäischen Patentanmeldung EP 0 500 032 A1 versucht, die Induktivität einer Stromrichterschaltungsanordnung mit zwei schaltbaren Bauelementen pro Phase dadurch zu minimisieren, dass das schaltbare Bauelement und die Freilaufdiode einen Kommutierungszweiges eng benachbart vorgesehen sind. Für die in dieser Schrift angegebene Schaltung mag dies genügen, bei komplizierter aufgebauten Schaltungsanordnungen mit mehreren Stromkreisen reichen die angegebenen Massnahmen noch nicht.

Im Deutschen Gebrauchsmuster G 93 09 428.0 wird ein wassergekühltes Stromrichtermodul angegeben. Das Modul umfasst zwei Spannverbände mit Stromrichterventilen, wobei die Spannverbände übereinander auf Luftstreckenabstand angeordnet sind. Die Verbindungen werden grossflächig und mit sehr geringem Abstand parallel ausgeführt, so dass sehr geringe Streuinduktivitäten erreicht werden sollen.

### Darstellung der Erfindung

Aufgabe der vorliegenden Erfindung ist es deshalb, eine Umrichterschaltungsanordnung anzugeben, welche durch einen möglichst niederinduktiven Aufbau ausgezeichnet ist.

Diese Aufgabe wird bei einer Umrichterschaltungsanordnung der eingangs genannten Art durch die Merkmale des ersten Anspruchs gelöst.

Eine erfindungsgemässe Umrichteranordnung besteht mindestens aus einem Phasenmodul, welches eine Phase einer Brückenschaltung umfasst und seinerseits aus zwei Zweigmodulen besteht. Die Zweigmodule weisen mindestens zwei in Serie geschaltet Schaltermodule auf, die ein Leistungshalbleiterbauelement inklusive dessen Schalter-, Beschaltungs-, Freilauf- und Strombegrenzungsnetzwerke umfassen. Die Zweigmodule innerhalb eines Phasenmoduls sind so angeordnet, dass ein Kommutierungsstromkreis, welche durch den Gleichspannungszwischenkreis, den Plus- bzw. Minusanschluss und die entsprechenden Zweigmodule gebildet wird, eine möglichst kleine Stromkreisfläche umfasst. Dadurch erreicht man insbesondere, dass ein Schalter höchstens 500 nH zur Streuinduktivität eines Phasenmoduls beiträgt. Die Streuinduktivität des Kommutierungsstromkreises ist proportional der Stromkreisfläche, so dass bei einer möglichst kleinen Stromkreisfläche am Halbleiterschalter nur eine geringe Spannung erzeugt wird.

Kern der Erfindung ist es nun, dass die Zweigmodule räumlich parallel oder senkrecht zu einer zwischen dem Plus- und Minusanschluss verlaufenden Hauptrichtung angeordnet sind. Ausserdem ist das Beschaltungsnetzwerk im wesentlichen senkrecht zur Hauptrichtung angeordnet, und die Leistungshalbleiterschalter sind in einem gemeinsamen Schalterstapel angeordnet.

Vorzugsweise werden die Zweigmodule bzw. deren Schaltermodule in der Form eine "U" oder mäanderförming angeordnet. Eine weitere Ausführungsform ist dadurch gekennzeichnet, dass eine gerade Anzahl von Phasenmodulen vorgesehen ist und die Zweige von je zwei Phasenmodulen bezüglich einer Trennebene spiegelsymmetrisch angeordnet sind. Die Trennebene wird dabei durch die Stromschiene entweder des Plus- oder des Minusanschlusses gebildet.

Allen Ausführungsbeispielen ist gemeinsam, dass die Leistungshalbleiterschalter und deren Dioden des Freilaufkreises bzw. deren Antiparalleldioden vorzugsweise in separaten Stapeln angeordnet werden. Werden zudem mehrere Ebenen von U- oder mäanderförmig angeordneten Zweig- bzw. Schaltermodulen nebeneinander oder übereinander aufgestellt, so werden die Schaltermodule vorzugsweise so angeordnet, dass sich die magnetischen Felder, die sich in Leiterschlaufen, welche durch die Schaltermodule gebildet werden, in den benachbarten Ebenen gerade aufheben.

Eine weitere Variante des erfindungsgemässe Aufbaus ist durch eine koaxiale Anordnung ausgezeichnet. Hierbei bildet der Plus- bzw. Minusanschluss je einen hohlen Zylinder, welche die Zweig- bzw. Schaltermodule umgeben.

Weitere Ausführungsbeispiele ergeben sich aus den entsprechenden abhängigen Ansprüchen.

Der Vorteil des erfindungsgemässen Leistungshalbleitermoduls besteht darin, dass sein Aufbau durch die Wahl der räumlichen Anordnung der Elemente des Moduls sehr niederinduktiv ist. Dadurch baut sich bei einer Änderung des Stromes durch die Schalter eine möglichst kleine Spannung auf. Demzufolge sinken die Schaltverluste erheblich und die Anordnung kann mit höheren Frequenzen betrieben werden.

Nachfolgend wird die Erfindung anhand von Ausführungsbeispielen im Zusammenhang mit den Zeichnungen näher erläutert.

Es zeigen:
- **Fig. 1**: Das Ersatzschaltbild eines Phasenmoduls;
- **Fig. 2**: Das Ersatzschaltbild zweier Phasenmodule;
- **Fig. 3a,b**: Den mechanischen Aufbau der Umrichteranordnung nach einem ersten Ausführungsbeispiel von oben und von der Seite;
- **Fig. 4a,b**: Den mechanischen Aufbau der Umrichteranordnung nach einem weiteren Ausführungsbeispiel von oben und von der Seite,
- **Fig 5a-f**: Weitere Möglichkeiten der erfindungsgemässen Anordnung der Zweig- bzw. Schaltermodule;
- **Fig. 6**: Die Anordnung der Zweigmodule nach einer weiteren Ausführungsform;
- **Fig. 7**: Die dreidimensionale Darstellung der Anordnung der Schaltermodule; sowie
- **Fig. 8**: Eine weitere Variante des erfindungsgemässen Aufbaus mit koaxialer Anordnung.

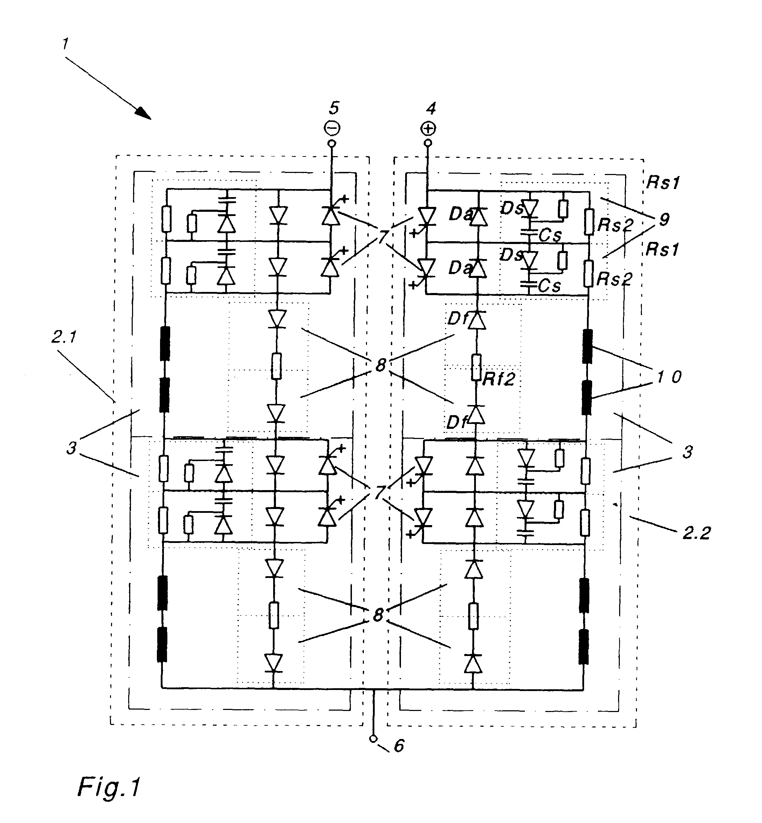

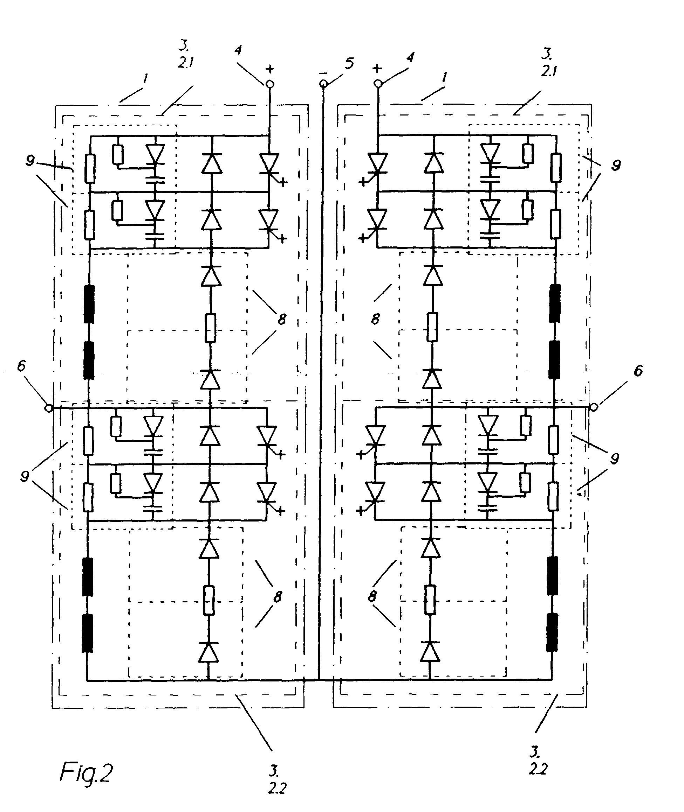

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen. In den Figuren 1 und 2 sind die Bauelemente der Übersicht halber nur in einem Schaltermodul der Figur 1 bezeichnet.

### Wege zur Ausführung der Erfindung

**Figur 1** zeigt das Ersatzschaltbild eines einzelnen Phasenmoduls (1) einer Brückenschaltung der erfindungsgemässen Umrichterschaltungsanordnung. Ein solches Phasenmodul (1) umfasst zwei Zweigmodule (2.1 und 2.2), welche ihrerseits mindestens ein - im dargestellten Fall je zwei - Schaltermodule (3) umfassen. Mit Schaltermodul (3) wird im folgenden ein Leistungshalbleiterbauelement bezeichnet, welches mindestens einen Leistungshalbleiterschalter (7) mit zugehörigem Netzwerk für den Freilauf (8), Beschaltung (9) oder Strombegrenzung (10) umfasst. Schaltungstechnisch ist diese Anordnung und deren Funktionsweise bekannt und soll deshalb hier nicht mehr weiter erläutert werden.

Der Strom fliesst im Betrieb entweder durch das eine Zweigmodul (2.1) oder das andere Zweigmodul (2.2) zur Last. Beim Umschalten muss ein Kommutierungsstrom aufgebaut werden, welcher im sog. Kommutierungsstromkreis, der durch den Gleichspannungszwischenkreis (nicht dargestellt), den Plus- (4) bzw. Minusanschluss (5) und die Zweigmodule (2.1, 2.2) gebildet wird, fliesst. Die Induktivität dieses Kommutierungsstromkreises soll nach der Erfindung minimiert werden. Dies wird dadurch erreicht, dass die Stromkreisfläche des Kommutierungsstromkreises möglichst gering gewählt wird.

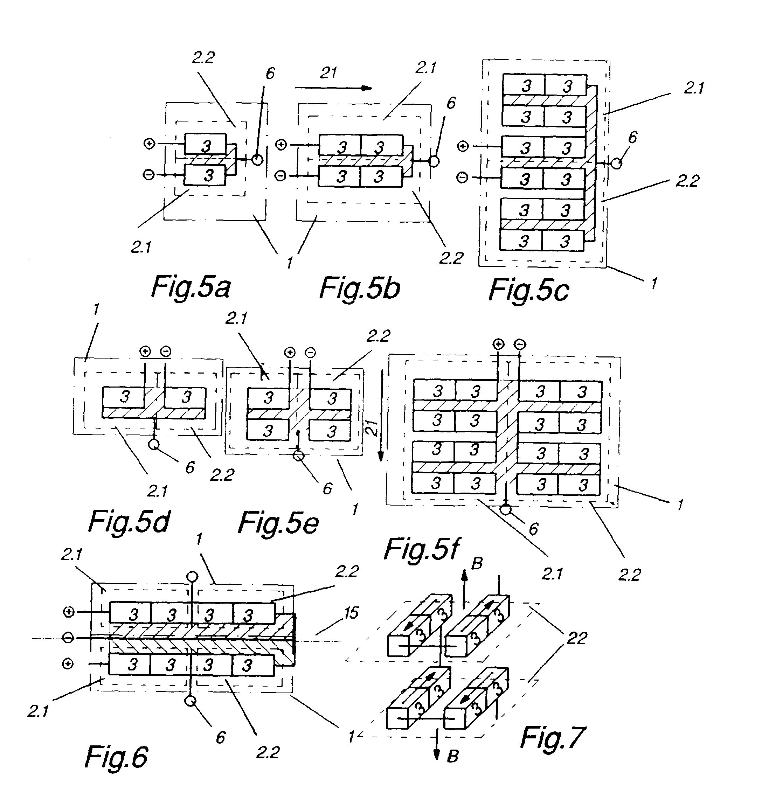

Die **Figuren 5a-f** zeigen verschiedene Möglichkeiten wie dies erreicht werden kann. Grundsätzlich gibt es die beiden Varianten, dass die Zweigmodule entweder parallel (Figuren 5a-c) zu einer Hauptrichtung (21), die entlang einer Verbindungslinie vom Plus- bzw. Minusanschluss zum Lastanschluss verläuft, angeordnet werden oder senkrecht dazu. Es spielt dabei keine Rolle, ob die Zweigmodule (2.1, 2.2) nur ein Schaltermodul (3) - Figur 5a - oder mehrere Schaltermodule (3) - Figur 5b - umfassen. Die Zweigmodule (2.1, 2.2) können entweder in der Form eines "U" (Figuren 5a, 5b bzw. Figuren 5d, 5e) oder mäanderförmig (Figur 5c bzw. Figur 5f) angeordnet sein. Allen Varianten ist gemeinsam, dass die Stromkreisfläche des Kommutierungsstromkreises, die schraffiert dargestellt ist, möglichst klein gehalten wird.

Normalerweise besteht ein Umrichter aus mehreren solcher Phasenmodule (1) - bei Dreiphasensystemen insbesondere aus dreien. Diese werden natürlich alle nach einer der Figuren 5a-f aufgebaut sein. In dem Falle, wo eine gerade Anzahl von Phasenmodulen vorgesehen wird, ist jedoch noch eine weitere, in **Figur 6** dargestellte Variante möglich. Das entsprechende Ersatzschaltbild zeigt **Figur 2**.

Hier sind die Zweigmodule (2.1, 2.2) von je zwei Phasenmodulen (1) bezüglich einer Trennebene (15) spiegelsymmetrisch angeordnet. Die Plus- und Minusanschlüsse (4 u. 5) sind auf einer Seite angeordnet, die Lastanschlüsse werden seitlich weggeführt. Entlang der Trennebene (15) verläuft entweder die Stromschiene des Plus- oder des Minusanschlusses (Figur 6).

Die Schaltermodule (3) der Zweigmodule (2.1, 2.2) können natürlich auch übereinander oder nebeneinander angeordnet sein. Ausschnittsweise ist in **Figur 7** dargestellt, wie zwei Ebenen von Schaltermodulen (3) angeordnet werden sollen. Von Vorteil ist es insbesondere, wenn die Schaltermodule (3) so zusammengeschaltet werden, dass sich die magnetischen Felder B, dargestellt durch Pfeile, von zwei gegenüberliegenden Ebenen (22) gerade aufheben. Die Felder werden dabei durch den Strom in den Leiterschleifen, welche z.B. eine U-förmige Anordnung bildet, induziert.

Allen Ausführungsbeispielen ist gemeinsam, dass die Leistungshalbleiterschalter (7) und die Freilauf- (Df) bzw. Antiparalleldioden (Da) in getrennten, parallel verlaufenden Stapeln, die mittels einer Einspannvorrichtung (18) zusammengehalten werden, angeordnet werden.

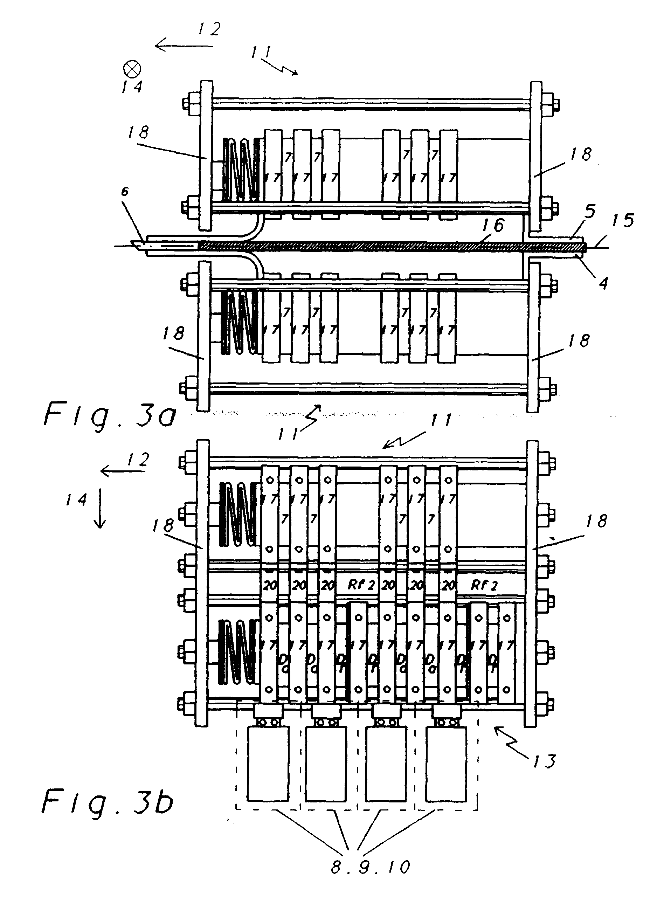

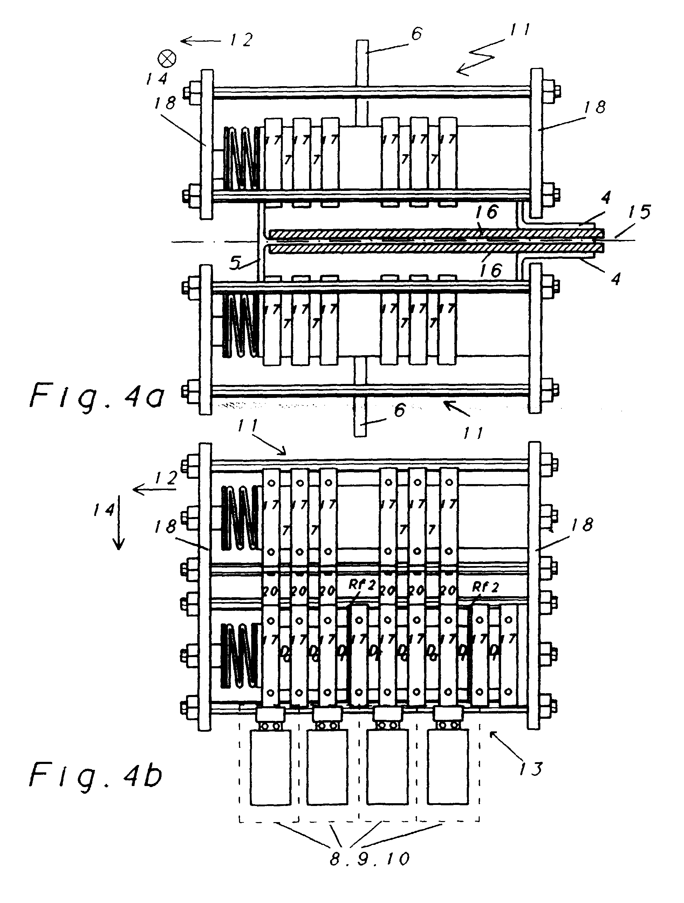

Die Figuren 3a,b und 4a,b zeigen diese Anordnung für die Schaltungen nach den Figuren 1 und 2.

Das in Figur 1 dargestellte Phasenmodul besteht aus den zwei Zweigmodulen (2.1 u. 2.2) mit insgesamt vier Schaltermodulen (3), welche in Serie geschaltet sind und an den Plus- (4) und an den Minus-Anschluss (5) z.B. eines Gleichspannungszwischenkreises angeschlossen werden können. Jedem Leistungshalbleiterschalter (7) ist eine Diode (Da) antiparallel und ein Beschaltungsnetzwerk (9) parallel geschaltet. Zudem ist pro Schaltermodul (3) ein Freilaufkreis (8) und eine Stromanstiegsbegrenzungsdrossel (10) vorgesehen. Die Stromanstiegsbegrenzungsdrosseln (10) können - im Gegensatz zu dargestellten Ausführungsform - genauso gut auch zusammengefasst werden.

Der gemeinsame Anschluss in der Mitte des Phasenmoduls (1) bildet den Lastanschluss (6). In bekannter Weise werden die Leistungshalbleiterschalter (7) nun so angesteuert, dass der Lastanschluss (6) abwechslungsweise mit dem Plus-Anschluss (4) und dem Minus-Anschluss (5) verbunden wird. Die Anzahl der in Serie geschalteten Leistungshalbleiterschalter (7) kann dabei so gewählt werden, dass die geforderte Spannungsfestigkeit resultiert. Sie ist also nicht auf die dargestellten zwei beschränkt. Ebenso können mehr als zwei Schaltermodule (3) pro Zweigmodul (2.1 od. 2.2) zusammengeschaltet werden.

Vorzugsweise werden als Leistungshalbleiterschalter (7) Abschaltthyristoren oder Gate-Turn-Off-Thyristoren (GTOs) verwendet. In diesem Fall besteht der Freilaufkreis (8) aus einer Freilaufdiode (Df) sowie einem in Serie mit den Freilaufdioden (Df) geschalteten, gemeinsamen Widerstand (Rf2). Es ist nicht unbedingt nötig, dass pro Schalter eine Freilaufdiode (Df) vorgesehen ist, genauso gut kann nur eine pro Schaltermodul vorgesehen werden. Das Beschaltungsnetzwerk (9) weist eine Beschaltungsdiode (Ds), einen parallel geschalteten Widerstand (Rsl), einen dazu ein Serie geschalteten Kondensator (Cs) und einen zur gesamten Beschaltung parallel geschalteten Widerstand (Rs2) auf. Auf die Wirkungsweise dieser Elemente wird nicht näher eingegangen, da sie als bekannt vorausgesetzt wird.

Nach der Erfindung werden nun die Leistungshalbleiterschalter (7) in einem Schalterstapel (11) und die Antiparalleldioden (Da) und Freilaufdioden (Df) in einem eigenen Diodenstapel (13) angeordnet.

Wie **Figur 3a** zeigt, bilden die Leistungshalbleiterschalter des ersten Zweigmoduls (2.1) und diejenigen des zweiten (2.2) je einen Schalterstapel (11). **Figur 3b** zeigt die Stapelanordnung von der Seite. Oben ist wieder einer der Schalterstapel (11) dargestellt, unten der Diodenstapel (13). Die Stapel werden jeweils durch eine Einspannvorrichtung (18) zusammengehalten. In Figur 3a ist weiter der Plus- (4) und der Minus-Anschluss (5) ersichtlich, welcher von der rechten Stapelseite zu je einem der benachbarten Schalterstapeln (11) führt. Auf der gegenüberliegenden Stapelseite sind die Schalterstapel (11) verbunden und bilden den Lastanschluss (6). Die Leistungshalbleiterschalter (7) der Schalterstapel (11) sind dabei mit den zugehörigen Dioden (Da, Df) des darunter angeordneten Diodenstapels (13) über Verbindungsstücke (20) verbunden.

Zwischen den Leistungshalbleiterschaltern (7) und den Dioden (Da, Df) eines Stapels sind jeweils Kühldosen (17) angeordnet. Die Kühldosen (17) werden vorzugsweise von einer Kühlflüssigkeit durchflossen.

Der gemeinsame Widerstand (Rf2) des Freilaufkreises wird vorzugsweise als flächiger Widerstand direkt zwischen zwei Freilaufdioden (Df) eines Diodenstapels (13) integriert. Die übrigen Elemente der Beschaltung (9) und des Freilaufkreises (8) sowie die Stromanstiegsbegrenzungsdrossel (10) werden vorzugsweise unterhalb der Diodenstapel (13) angeordnet, was schematisch in Figur 3b angedeutet ist.

Grundsätzlich ist die erfindungsgemässe Stapel-Anordnung also dadurch gekennzeichnet, dass
- die Leistungshalbleiterschalter der Schaltermodule zu einem Schalterstapel zusammengefasst sind, wobei die Stapel eine Stapelrichtung definieren;
- die Freilauf- und Antiparalleldioden der Schaltermodule einen Diodenstapel bilden, wobei die Dioden entlang einer Verbindungsrichtung, welche im wesentlichen senkrecht zur Stapelrichtung verläuft, mit den entsprechenden Schaltern verbunden sind und die Diodenstapel in Verbindungsrichtung unterhalb der Schalterstapel angeordnet sind; und
- die Schalter- bzw. Diodenstapel des einen Zweigmoduls von denjenigen des anderen durch eine Ebene getrennt werden, deren Normalenvektor sowohl auf die Stapel- als auch auf die Verbindungsrichtung senkrecht steht.

In den **Figuren 4a und 4b** ist der mechanische Aufbau des Ausführungsbeispiels nach Figur 2 dargestellt. Es sind wiederum vier Schaltermodule (3) vorhanden, welche prinzipiell gleich aufgebaut sind wie die des ersten Ausführungsbeispiels. Im Gegensatz zur Figur 1 stellt jede Hälfte der Schaltermodule (3) nun aber selber ein vollständiges Phasenmodul (1) dar. Dies widerspiegelt sich nun auch in einem leicht verschiedenen Aufbau der Stapel. Wie aus Figur 4a ersichtlich ist, sind die beiden nebeneinander liegenden Enden einer Seite der Schalterstapel (11) mit dem Plus-Anschluss (4), diejeningen der anderen Seite mit dem Minus-Anschluss (5) verbunden. Der umgekehrte Fall wäre natürlich auch möglich. Die Lastanschlüsse (6) der beiden Phasenmodule (1) sind an der Stellen des gemeinsamen Anschlusses jedes Teils des Brückenzweigs aus dem Stapel geführt.

Die Anordnung der Diodenstapel (13), der Freilaufelemente und der Beschaltungselemente entspricht derjenigen des ersten Ausführungsbeispiels. Deshalb wird darauf an dieser Stelle nicht mehr näher eingegangen.

Beiden Ausführungsbeispielen ist gemeinsam, dass die Stromschienen der Plus- und Minus-Anschlüsse mittels einer Isolationsplatte (16), welche entlang der trennenden Ebene (15) verläuft, getrennt werden können. Falls der Abstand der beiden Stromschienen sehr gering gewählt wird, kann dies sogar zur Notwendigkeit werden.

Bis jetzt wurden immer Ausführungsbeispiele besprochen, welche insgesamt 8 Leistungshalbleiterschalter aufweisen. Dies ist nun aber nicht unbedingt als Notwendigkeit zu betrachten. Genauso gut könnten die Zweigmodule (2.1, 2.2) des Phasenmoduls (1) des ersten Ausführungsbeispiels je aus 6 Schalter, d.h. z.B. aus 3 Schaltermodulen à 2 Schalter bzw. 2 Schaltermodule à 3 Schalter, bestehen. Ebenso ist es denkbar, dass jedes Phasenmodul (1) des zweiten Ausführungsbeispiels aus vier Schaltermodulen à 2 Schalter oder 2 Schaltermodulen à 3 Schalter besteht. Die erfindungsgemässe Stapelanordnung ist also nicht auf eine bestimmte Anzahl von Elementen beschränkt. Wichtig ist nur, dass in jeder Hälfte des Moduls getrennte Schalter- und Diodenstapel gebildet werden und die Stapel der zwei Hälften durch die beschriebene Trennebene voneinander separiert sind.

Der gerade diskutierte mechanische Aufbau ist selbstverständlich nicht nur auf diese beiden Ausführungsbeispiele beschränkt, sondern kann sinngemäss auf alle in den Figuren 5a-f, 6 und 7 angewendet werden.

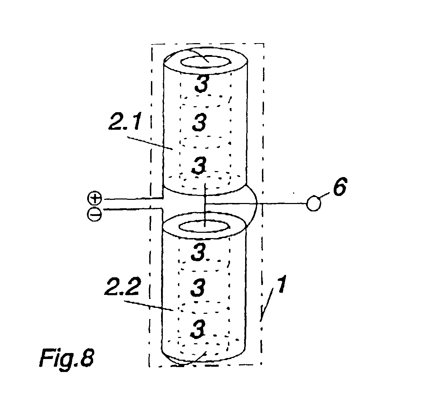

In **Figur 8** ist schliesslich noch eine weitere Variante des erfindungsgemässen Aufbaus dargestellt. Hier bilden der Plus- (4) und der Minusanschluss (5) je einen hohlen Zylinder, welche die Schaltermodule (3) bzw. Zweigmodule (2.1, 2.2) koaxial umgeben. Der Lastanschluss (6) kann zwischen dem Zylinder des Plusanschlusses (4) und demjenigen des Minusanschlusses (5) herausgeführt sein. Auf diese Weise erreicht man ebenfalls einen sehr induktivitätsarmen Aufbau.

Der erläuterte, mechanische Aufbau aus getrennten Schalte- und Diodenstapeln ermöglicht zusammen mit den nur prinzipiell dargestellten Anordnungen nach den Figuren 5a-f, 6 und 7 einen sehr induktivitätsarmen Aufbau. Demzufolge weist also eine erfindungsgemässe Umrichteranordnung einen optimalen Aufbau bezüglich Induktivitäten auf. Dadurch kann die Spannung über den Schaltern bei Kommutierungsvorgängen gering gehalten werden. Als Folge davon sind die Schaltverluste geringer und die Umrichteranordnung kann mit höheren Frequenzen betrieben werden.

### Bezeichnungsliste

- 1: Phasenmodul
- 2.1, 2.2: Zweigmodule
- 3: Schaltermodule
- 4: Plus-Anschluss
- 5: Minus-Anschluss
- 6: Lastanschluss
- 7: Leistungshalbleiterschalter
- 8: Freilaufkreis
- 9: Beschaltungsnetzwerk
- 10: Stromanstiegsbegrenzungsdrossel
- 11: Schalterstapel
- 12: Stapelrichtung
- 13: Diodenstapel
- 14: Verbindungsrichtung
- 15: Trennebene
- 16: Isolationsplatte
- 17: Kühldosen
- 18: Einspannvorrichtung
- 19: Ansteuereinheiten, Gate-Units
- 20: Verbindungsstücke
- 21: Hauptrichtung
- 22: Ebenen
- Df: Freilaufdiode
- Da: Antiparalleldiode
- Ds: Beschaltungsdiode
- Rf2: Freilaufwiderstand
- Rs1, Rs2: Beschaltungswiderstand
- Cs: Beschaltungskondensator
- B: Magnetfeld

## Patentansprüche

1. Umrichteranordnung umfassend
a) mindestens ein Phasenmodul (1) einer Brückenschaltung, wobei jedes Phasenmodul (1) aus zwei Zweigmodulen (2.1, 2.2) besteht, die in Serie geschaltet sind und mit einem Plus- (4) bzw. Minusanschluss (5) eines Gleichspannungszwischenkreises verbunden sind, wobei der gemeinsame, zentrale Anschluss der Zweigmodule (2.1, 2.2) einen Lastanschluss (6) bildet und die Zweigmodule (2.1, 2.2) mindestens ein Schaltermodul (3) umfassen, welche Schaltermodule (3) mindestens einen Leistungshalbleiterschalter (7) mit zugehörigen Netzwerken für Beschaltung (9), Freilauf (8) und Strombegrenzung (10) umfassen, wobei
b) die Zweigmodule (2.1, 2.2) innerhalb eines Phasenmoduls (1) so angeordnet sind, dass ein Kommutierungsstromkreis (20), welcher durch den Gleichspannungszwischenkreis, den Plusanschluss (4), den Minusanschluss (5) und die Zweigmodule (2.1 u. 2.2) gebildet wird, eine möglichst kleine Stromkreisfläche umfasst, dass insbesondere jeder Schalter (7) höchstens 500 nH zu einer Gesamt-Streuinduktivität eines Phasenmoduls (1) beiträgt;
dadurch gekennzeichnet, dass
c) die Zweigmodule (2.1, 2.2) parallel oder senkrecht zu einer zwischen dem Plus- bzw. Minusanschluss (4 bzw. 5) und dem Lastanschluss (6) verlaufenden Hauptrichtung (21) angeordnet sind,
d) die Beschaltungsnetzwerke (9) parallel zu den Leistungshalbleiterschaltern geschaltet und im wesentlichen senkrecht zur Hauptrichtung angeordnet sind;
e) die Leistungshalbleiterschalter (7) der Schaltermodule (3) mindestens eines Teils der Zweigmodule (2.1, 2.2) in einem gemeinsamen Schalterstapel (11) entlang einer Stapelrichtung (12) angeordnet sind.

2. Umrichteranordnung nach Anspruch 1, dadurch gekennzeichnet, dass die Zweigmodule (2.1, 2.2) räumlich so angeordnet sind, dass sie die Schenkel eines "U" bilden.

3. Umrichteranordnung nach Anspruch 1, dadurch gekennzeichnet, dass die Schaltermodule (3) der Zweigmodule (2.1, 2.2) räumlich mäanderförmig angeordnet sind.

4. Umrichteranordnung nach Anspruch 1, dadurch gekennzeichnet, dass
a) eine gerade Anzahl von Phasenmodulen (1) vorgesehen ist,
b) die Zweigmodule (2.1 bzw. 2.2) von je zwei Phasenmodulen (1) bezüglich einer Trennebene (15), welche durch eine Stromschiene entweder des Plus- (4) oder Minusanschlusses (5) gebildet wird, spiegelsymmetrisch angeordnet sind, und
c) die Plus- bzw. Minusanschlüsse (4 bzw. 5) auf derselben Seite der Umrichteranordnung angeordnet sind.

5. Umrichteranordnung nach einem der Ansprüche 1 oder 4, dadurch gekennzeichnet, dass die Freilaufkreise (8) in Serie mit den Leistungshalbleiterschaltern (7) geschaltet sind und im wesentlichen mindestens eine Freilaufdiode (Df) umfassen, dass antiparallel zu den Leistungshalbleiterschaltern (7) je eine Antiparalleldiode (Da) geschaltet ist und dass die Freilaufdioden (Df) und Antiparalleldioden (Da) der Leistungshalbleiterschalter (7) in einem eigenen, ebenfalls entlang der Stapelrichtung (12) verlaufenden Diodenstapel angeordnet (13) sind, wobei die Leistungshalbleiterschalter (7) mit ihren Antiparalleldioden (Da) entlang einer Verbindungsrichtung (14), die im wesentlichen senkrecht zur Stapelrichtung (12) verläuft, elektrisch verbunden sind.

6. Umrichteranordnung nach Anspruch 5, dadurch gekennzeichnet, dass
a) zwischen den Dioden (Da, Df) bzw. den Schaltern (7) der Dioden- bzw. Schalterstapel (13 bzw. 12) Kühldosen (17) angeordnet sind, und
b) die Schalter- bzw. Diodenstapel (11 bzw. 13) mittels einer Einspannvorrichtung (18) zusammengehalten werden.

7. Umrichteranordnung nach Anspruch 6, dadurch gekennzeichnet, dass sprechenden Schaltermodule geschaltet ist und als zwischen den Freilaufdioden (Df) liegender, im Diodenstapel integrierter, flächiger Widerstand ausgeführt ist.

8. Umrichteranordnung nach Anspruch 7, dadurch gekennzeichnet, dass als Leistungshalbleiterschalter (7) Abschaltthyristoren vorgesehen sind, welche durch Ansteuereinheiten (19) angesteuert werden und welche Ansteuereinheiten in Verbindungsrichtung (14) oberhalb der Schalterstapel (11) angeordnet sind.

9. Umrichteranordnung nach einem der Ansprüche 2 oder 3, dadurch gekennzeichnet, dass
a) in einem Zweigmodul (2.1 oder 2.2) mindestens zwei Ebenen (22) von U- oder mäanderförmig angeordneten Schaltermodulen über- oder nebeneinander angeordnet sind und
b) die Schaltermodule (3) so verbunden sind, dass ein magnetisches Feld, welches sich in Leiterschlaufen der Ebenen (22) von Schaltermodulen bilden kann, in entsprechenden Leiterschlaufen der gegenüberliegenden Ebenen (22) entgegengesetzte Richtung aufweist.

10. Umrichteranordnung nach Anspruch 1, dadurch gekennzeichnet, dass der Plus- (4) und der Minusanschluss (5) je einen hohlen Zylinder bilden, welche die Zweig- (2.1, 2.2) bzw. Schaltermodule (3) koaxial umgeben.

## Claims

1. Converter arrangement comprising
a) at least one phase module (1) of a bridge circuit, each phase module (1) comprising two branch modules (2.1,2.2) which are connected in series and are connected respectively to a positive connection (4) and to a negative connection (5) of a DC intermediate circuit, the common, central connection of the branch modules (2.1, 2.2) forming a load connection (6) and the branch modules (2.1, 2.2) comprising at least one switch module (3), which switch modules (3) comprise at least one power semiconductor switch (7) with associated networks for circuitry (9), a freewheel (8) and a current limiter (10),
b) the branch modules (2.1, 2.2) being arranged within a phase module (1) such that a commutation circuit (20), which is formed by the DC intermediate circuit, the positive connection (4), the negative connection (5) and the branch modules (2.1, 2.2), comprises a circuit area which is as small as possible, that in particular each switch (7) contributes at most 500 nH to a total stray inductance of a phase module (1);
characterized in that
c) the branch modules (2.1, 2.2) are arranged parallel to or at right angles to a main direction (21) running between the positive and negative connections (4 and 5) and the load connection (6),
d) the circuitry networks (9) are connected in parallel with the power semiconductor switches and are arranged essentially at right angles to the main direction;
e) the power semiconductor switches (7) of the switch modules (3) of at least some of the branch modules (2.1, 2.2) are arranged along a stack direction (12) in a common switch stack (11).

2. Converter arrangement according to Claim 1, characterized in that the branch modules (2.1, 2.2) are arranged spatially such that they form the limbs of a "U".

3. Converter arrangement according to Claim 1, characterized in that the switch modules (3) of the branch modules (2.1, 2.2) are arranged spatially in a meandering shape.

4. Converter arrangement according to Claim 1, characterized in that
a) an even number of phase modules (1) are provided,
b) the branch modules (2.1, 2.2) of two phase modules (1) in each case are arranged in mirror-image symmetry with respect to a separating plane (15) which is formed by a busbar of either the positive connection (4) or the negative connection (5), and
c) the positive and negative connections (4 and 5) are arranged on the same side of the converter arrangement.

5. Converter arrangement according to one of Claims 1 or 4, characterized in that the freewheel circuits (8) are connected in series with the power semiconductor switches (7) and comprise essentially at least one freewheeling diode (Df), in that one reverse-connected parallel diode (Da) is reverse-connected in parallel with each of the power semiconductor switches (7), and in that the freewheeling diodes (Df) and reverse-connected parallel diodes (Da) of the power semiconductor switches (7) are arranged (13) in a dedicated diode stack which likewise runs along the stack direction (12), the power semiconductor switches (7) being electrically connected to their reverse-connected parallel diodes (Da) along a connection direction (14) which runs essentially at right angles to the stack direction (12).

6. Converter arrangement according to Claim 5, characterized in that
a) cooling boxes (17) are arranged between the diodes
b) the switch stack and the diode stack (11 and 13) are held together by means of a clamping-in device (18).

7. Converter arrangement according to Claim 6, characterized in that a common freewheeling resistor (Rf2) is provided for in each case two switch modules (3), which freewheeling resistor is connected between the freewheeling diodes (Df) of the corresponding switch modules and is designed as a planar resistor which is integrated in the diode stack and is located between the freewheeling diodes (Df).

8. Converter arrangement according to Claim 7, characterized in that turn-off thyristors are provided as power semiconductor switches (7), which thyristors are driven by drive units (19) which are arranged above the switch stacks (11) in the connection direction (14).

9. Converter arrangement according to one of Claims 2 or 3, characterized in that
a) at least two planes (22) of switch modules, which are arranged in a U-shape or a meandering shape, are arranged one above the other or side-by-side in a branch module (2.1 or 2.2), and
b) the switch modules (3) are connected such that a magnetic field which can form in conductor loops of the planes (22) of switch modules runs in the opposite direction in corresponding conductor loops of the opposite planes (22).

10. Converter arrangement according to Claim 1, characterized in that the positive connection (4) and the negative connection (5) each form a hollow cylinder, which cylinders coaxially surround the branch modules (2.1, 2.2) and switch modules (3).

## Revendications

1. Dispositif convertisseur comprenant
a) au moins un module de phase (1) d'un circuit de pont, chaque module de phase (1) se composant de deux modules de dérivation (2.1, 2.2) qui sont branchés en série et qui sont reliés avec une borne positive (4) ou une borne négative (5) d'une boucle continue intermédiaire, la borne centrale commune des modules de dérivation (2.1, 2.2) formant une borne de charge (6) et les modules de dérivation (2.1, 2.2) comprenant au moins un module de commutation (3), lesquels modules de commutation (3) comprennent au moins un commutateur à semiconducteur de puissance (7) avec ses réseaux associés pour le filtrage (9), la roue libre (8) et la limitation de courant (10),
b) les modules de dérivation (2.1, 2.2) étant disposés à l'intérieur d'un module de phase (1) de manière à ce qu'une boucle de commutation (20), laquelle se compose de la boucle continue intermédiaire, de la borne positive (4), de la borne négative (5) et des modules de dérivation (2.1, 2.2), présente une surface de boucle la plus petite possible afin notamment que chaque commutateur (7) représente un maximum de 500 nH de l'inductance de fuite totale d'un module de phase (1) ;
c) les modules de dérivation (2.1, 2.2) sont disposés parallèlement ou perpendiculairement par rapport à un sens principal (21) s'étendant entre la borne positive ou négative (4 ou 5) et la borne de charge (6) ;
d) les réseaux de filtrage (9) sont branchés en parallèle avec les commutateurs à semiconducteur de puissance et sont disposés pour l'essentiel perpendiculairement au sens principal ;
e) les commutateurs à semiconducteur de puissance (7) des modules de commutation (3), au moins dans une partie des modules de dérivation (2.1, 2.2), sont disposés dans une pile de commutateurs (11) commune le long d'un sens de pile (12).

2. Dispositif convertisseur selon la revendication 1, caractérisé par le fait que les modules de dérivation (2.1, 2.2) sont disposés dans l'espace de manière à ce qu'ils forment les branches d'un « U ».

3. Dispositif convertisseur selon la revendication 1, caractérisé par le fait que les modules de commutation (3) des modules de dérivation (2.1, 2.2) sont disposés dans l'espace en forme de rectangle.

4. Dispositif convertisseur selon la revendication 1, caractérisé par le fait que
a) il est prévu un nombre pair de modules de phase (1),
b) les modules de dérivation (2.1 ou 2.2) de chaque paire de modules de phase (1) sont disposés selon une symétrie en miroir par rapport à un plan de séparation (15), lequel est formé par un rail de courant de la borne positive (4) ou négative (5), et
c) les bornes positive ou négative (4 ou 5) sont disposées du même côté du dispositif convertisseur.

5. Dispositif convertisseur selon l'une des revendications 1 ou 4, caractérisé par le fait que les boucles de roue libre (8) sont branchées en série avec les commutateurs à semiconducteur de puissance (7) et comprennent pour l'essentiel au moins une diode de roue libre (Df), qu'une diode en tête-bêche (Da) est à chaque fois branchée en tête-bêche par rapport aux commutateurs à semiconducteur de puissance (7) et que les diodes en tête-bêche (Da) et les diodes de roue libre (Df) du commutateur à semiconducteur de puissance (7) sont disposées dans une propre pile de diodes (13) qui s'étend aussi parallèlement le long du sens de la pile (12), les commutateurs à semiconducteur de puissance (7) étant reliés électriquement à leurs diodes en tête-bêche (Da) le long d'un sens de liaison (14) qui est pour l'essentiel perpendiculaire au sens de la pile (12).

6. Dispositif convertisseur selon la revendication 5, caractérisé par le fait que
a) des boîtes de refroidissement (17) sont disposées entre les diodes (Da, Df) ou les commutateurs (7) des piles de diodes ou de commutateurs (13 ou 12), et
b) les piles de commutateurs ou de diodes (11 ou 13) sont maintenues au moyen d'un dispositif de serrage (18).

7. Dispositif convertisseur selon la revendication 6, caractérisé par le fait qu'une résistance de roue libre (Rf2) commune est prévue pour chaque paire de modules de commutation (3), laquelle est branchée entre les diodes de roue libre (Df) des modules de commutation correspondants et réalisée sous la forme d'une résistance plate logée entre les diodes de roue libre (Df), intégrée dans la pile de diodes.

8. Dispositif convertisseur selon la revendication 7, caractérisé par le fait que des thyristors blocables sont prévus comme commutateurs à semiconducteur de puissance (7), lesquels sont excités par des unités d'excitation (19) et lesdites unités d'excitation sont disposées dans le sens de la liaison (14) au-dessus de la pile de commutateurs (11).

9. Dispositif convertisseur selon l'une des revendications 2 ou 3, caractérisé par le fait que
a) dans un module de dérivation (2.1 ou 2.2), au moins deux plans (22) de modules de commutation arrangés en forme de U ou en forme de rectangle sont disposés l'un au-dessus de l'autre ou l'un à côté de l'autre, et
b) les modules de commutation (3) sont reliés de telle manière qu'un champ magnétique, lequel peut se former dans les boucles conductrices des plans (22) des modules de commutation, présente un sens opposé à celui dans les boucles conductrices correspondantes des plans (22) opposés.

10. Dispositif convertisseur selon la revendication 1, caractérisé par le fait que les bornes positive (4) et négative (5) forment chacune un cylindre creux qui entoure de manière coaxiale les modules de dérivation (2.1, 2.2) ou de commutation (3).
